# EUROPEAN PATENT SPECIFICATION

(11) **EP 0 871 040 B1**
(45) Date of publication and mention of the grant of the patent: **23.06.2004**
(21) Application number: 98201053.0
(22) Date of filing: 02.04.1998
(51) Int. Cl.: G01R 35/04

(54) **Calibration method for an electronic electricity meter**
Kalibrierungsverfahren für einen elektronischen Elektrizitätszähler
Procédé d'étalonnage d'un compteur d'électricité

(30) Priority: 08.04.1997 GB 9707134
(43) Date of publication of application: 14.10.1998
(73) Proprietor: SCHLUMBERGER INDUSTRIES LIMITED, London, WC2B 6XH (GB)
(72) Inventor: Devane, Conor Joseph, 75007 Paris (FR)
(74) Representative: Feray, Valérie

(56) References cited:
- EP-A- 0 240 102
- GB-A- 2 227 896
- US-A- 5 402 082

## Description

The present invention relates to a method of calibration of an electronic electricity meter including a converter adapted to receive at least one analogue input signal and to provide a digital output signal dependant on at least the value of the input signal.

Converters of this kind as used in metering include, for example, a transconductance converter adapted to receive voltage and current input signals and to output a pulse signal representing the instantaneous power. In this case, the frequency of the pulse signal is dependant on the multiplied values of current and voltage. A similar converter is that known as the mark space amplitude or MSA converter. More recently, electronic electricity meters have been proposed using Sigma-Delta converters to provide a digital output representative of the voltage and current measured, either as single isolated values or, as with the transconductance and MSA device, as a value representative of the voltage and current multiplied together.

An example of an electricity meter using an MSA converter is shown in the European Patents EP 0296968, EP 0296966. Equally, examples of a double Sigma-Delta converter providing a multiplied voltage and current output are described in EP 0607711, EP 0607712 and the French Patent FR 2570854.

Conventionally, calibration of such converters within the meter has been carried out in a number of ways. In the simplest and most common calibration procedure, the analogue input value of the on-line voltage is passed by a voltage divider, the value of one of the resistances in the divider being set during the calibration step, e.g. by laser-trimming the resistance. Other methods include use of EEpotentiometers (essentially an electronic potentiometer) and R-2R ladders, either controlled from a microprocessor or set by drilling tracks. Of these methods, laser-trimming is relatively inexpensive and the most common but suffers from a lack of precision, whilst the use of specific electronic components in the other methods greatly increases the cost of the device.

Alternative methods of calibration focus on processing of the pulsed output received in a microprocessor within the meter. In the case of such post-processing, the delay introduced due to the time required to accumulate the pulsed output can lead to problems of precision over short time periods, particularly if the frequency of the pulse output of the converter is not very high, as is often the case.

It is an object of the present invention to provide a calibration method which overcomes the disadvantages of the prior art methods and provides a simple low-cost way of implementing a calibration of the input signal.

The present invention is characterised in that the analogue input signal is fed to the converter via a gated resistance component, the resistance component being switched on and off according to a duty signal, the ratio of the on and off periods being chosen based on an external comparison of the input and output values so as to calibrate the digital output value relative to the analogue input.

The external comparison of the input and output and subsequent adjustment of the duty cycle may be carried out by a technician or by an automatic dedicated apparatus. As will be appreciated, the chopping duty cycle switches the input value between a base value and a second value when passed by the resistance component and the voltage perceived over a period of time by the converter will be an average of these two values. Generation of such a duty signal is relatively easy and may be carried out by even the simplest of microprocessors.

Equally, the hardware components necessary to implement the invention are quite simple. In one embodiment, the input signal may be fed via a resistor divider, comprising a first and second resistance in series together with a third gated resistance in parallel with the second resistance, the voltage over the second and third resistances being input to the converter.

Preferably, the duty signal may be provided by a microprocessor adapted to store one or more duty signal patterns. Typically, a series of duty signal patterns are stored in a dedicated PC, one of these patterns being selected as the duty signal and programmed into the microprocessor during the calibration of the meter.

Preferably, the analogue input signal corresponds to the voltage measured by the meter. The voltage is the most practical value for calibration purposes since it is relatively constant. However, the present invention is equally applicable to calibration of the current measured by the meter.

In one embodiment, the switching frequency of the gated signal (i.e. the frequency corresponding to a complete ON and OFF cycle of the signal) may correspond to and be synchronised with the line voltage frequency such that, for example, at least one switching transition is effected at the zero-crossing of the line voltage. Synchronisation in this manner provides certain advantages in relation to transients, harmonics induced etc. However, in many cases synchronisation may be dispensed with without incurring any problems.

In most of the prior art calibration systems the meter is calibrated only once, typically in relation to consumption for a normal or standard load. Equally, in the present invention, a single duty signal may be applied at all times. However, in some circumstances, for example, where a very low load is connected downstream of the meter, this may lead to inaccuracies and it may be advantageous to recalculate the calibration in these cases.

According to a particularly preferred embodiment of the present invention, a plurality of duty cycles is stored in a microprocessor within the meter, the microprocessor being adapted to apply one or more duty cycle or cycles in dependance on the magnitude of the output signal from the converter.

Unlike such methods as laser-trimming of a resistance, where a single calibration value is fixed for all time, the present invention enables a calibration of the meter dependant on the quantity of electricity consumed as represented by the output signal of the converter. This permits the meter to compensate for non-linearities in the measurement circuit which may become apparent, for example, at low-load conditions.

In a preferred embodiment, the microprocessor may be adapted to apply two duty cycles representing two calibration settings, the output of the converter being used to determine the proportion of time for which each duty cycle is applied.

By means of what amounts to a second duty control procedure, this embodiment provides a particularly simple and elegant way of dealing with two load conditions (e.g. low and normal) as well as conditions between the two. For example, at very low loads one duty cycle is applied, for normal loads a second duty cycle is applied, and for interim loads a mixture of the two duty cycles is applied.

Preferably, the duty cycle signal is defined by a binary bit pattern. In one embodiment of the two duty cycle realisation described above, the microprocessor may be adapted to provide a first binary pattern duty signal (e.g. normal load) unless interrupted by a pulse from the converter, in which case the second binary pattern signal (e.g. normal load) is applied.

In this way, the length of the binary pattern signal itself is used to measure the relative load conditions and the normal load duty cycle will be applied unless the pulse rate from the converter falls below a threshold defined by the packet length of the binary signal.

Throughout this application the term "converter" is intended to cover both analogue to digital converters which produce a value directly proportional to a single input value and devices which produce an output representative of a combination of input values e.g. as with an MSA or transconductance converter. The output may be a digital output or a pulsed signal.

The present invention has been described above in relation to a method of calibration of a meter. The invention further extends to a meter including the elements necessary for such a calibration, as described above.

There will now be described, by way of example only, a preferred embodiment of the invention with reference to the attached Figures, in which :
Fig. 1 shows a schematic of the elements of a meter adapted to carry out a calibration according to this embodiment of the invention ;
Fig. 2 shows the duty cycle signal used in Fig. 1 superimposed over the voltage applied to the input of the converter.

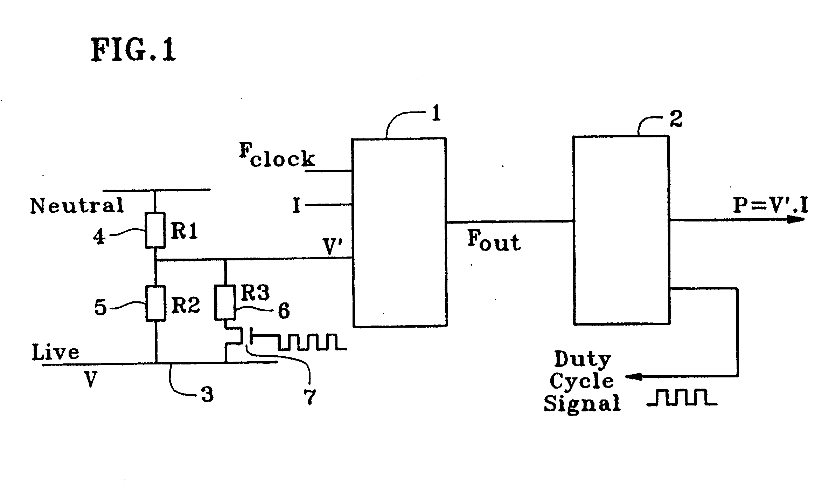

Figure 1 shows in schematic form the elements associated with the measurement and calibration functions of an electricity meter, comprising a converter 1, for example a transconductance, MSA or Sigma-Delta converter of a known type, together with a microprocessor 2 adapted to receive the output of the converter 1 and to output a duty signal used to control an input calibration circuit 3. The microprocessor 2 further provides a power output signal P representative of the power consumed which may be sent to a register and/or display to show power consumed.

The present invention relates specifically to the elements necessary to carry out calibration according to the present invention. As such, we do not propose to define any of the other conventional elements (register, display, voltage sensor etc.) normally present in an electronic meter. Further details regarding such devices (if needed) may be found in the patents mentioned in the introduction.

Referring to Figure 1, the following abbreviations are used :
I = Current
V = Uncalibrated voltage
V' = Calibrated voltage
Fclock = Clock signal to converter
Fout = Pulsed output representative of power provided by converter
P = Power output measurement provided by microprocessor

In the circuit 3 of Fig. 1, the uncalibrated voltage signal V is applied to a resistor divider comprising a first and second resistance 4,5 connected in series, together with a third gated resistance 6 in parallel with the second resistance 5. The gated resistance 6 is switched ON and OFF by means of an FET switch 7 which receives a duty cycle output signal from the microprocessor 2.

The duty cycle signal output by the microprocessor takes the form of a binary pattern such as 00000000, 10001000, 10101010, 11111111. In practice, patterns of any reasonable length e.g. up to 256 bits long may be used to provide a given resolution of calibration. The high and low bits in the patterns should be evenly distributed to improve convergence time for each pattern. A set of these patterns can be stored in the microprocessor, and one or more selected patterns used once the meter has been calibrated.

As will be apparant, the voltage V' output by the input circuit 3 will depend on the duty cycle applied to the FET switch. For a bit pattern 00000000, the FET switch will be permanently OFF and the voltage V' applied to the converter will be determined solely by the resistance 4,5 and will correspond to a maximum value Vmax. Similarly, for a bit pattern 11111111 the FET switch will be permanently ON and the voltage V' will correspond to a minimum voltage Vmin. For mixed bit patterns, such as 10101010, the voltage will be averaged over time to a value between the two.

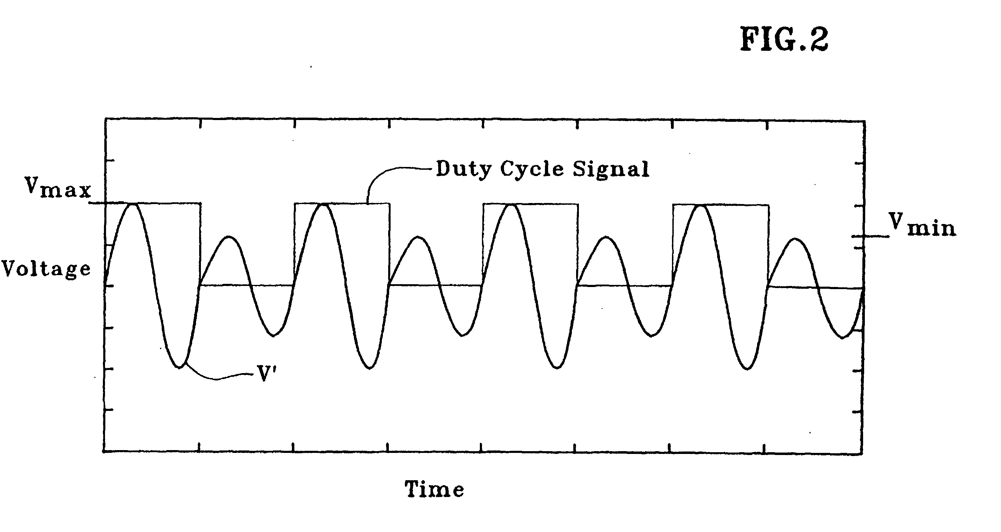

Figure 2 shows graphically the result of application of the 10101010 signal (50 % duty ratio) to produce the voltage V' sent to the input of the converter 1. As will be seen, the voltage changes between the minimum and maximum values, leading to a time averaged value V' corresponding to (Vmax + Vmin) / 2.

In Figure 2, the switching transitions of the duty cycle are shown synchronised with the zero crossings of the a.c. signal. However, whilst advantageous, this is not essential to the effective implementation of the invention.

In the simplest realisation, a power measurement is made during the calibration of the meter using a known value of current and voltage, and a single duty cycle pattern that gives the correct power output chosen from a number of patterns stored in a dedicated PC associated with the meter and programmed into the microprocessor. The calibration is carried out with respect to an integrated value of the output in order to assimilate the effects of the duty cycle on the input signal. This pattern will henceforth be applied at all times until such a time as it is decided that the meter needs to be recalibrated.

The choice of which pattern to use will be determined by the operator carrying out the calibration or, if automatised by the appropriate calibration equipment (e.g. a PC adapted to control the microprocessor to run through all the patterns until the pattern that gives the most accurate power value is found).

In more sophisticated embodiments, the meter can be calibrated for a range of loads so as to use two or more duty cycles depending on the load value as represented by the output signal Fout from the converter 1. In one particularly simple embodiment the microprocessor may include a first duty cycle pattern (A) to be applied in the case of a low load and a second duty cycle (B) to be applied for normal loads. The length of the bit pattern itself can be used as a threshold condition for determining which duty cycle signal to apply.

In particular, the following algorithm may be used by the microprocessor to control the application of the two duty cycle signals :
IF pulse output received from converter during pattern, THEN next pattern = pattern B
ELSE
Next pattern = pattern A

In this case, where the pulse output is consistently high (i.e. more than one pulse per pattern) the pattern B (normal load) will always be applied. Where the pulse output is consistently low the pattern A (low load) will be applied. For intermediate loads, the output pulse signal will automatically switch between the two patterns, such that the two will be applied in a greater or lesser relative proportion. Thus, the invention enables a sliding application of the two patterns, leading to a calibration curve that tracks the change in load. This second level duty control is a particularly simple and elegant way of obtaining a variable calibration value.

Although the description refers throughout to the use of microprocessor, it will of course be understood by one skilled in the art that other means capable of providing an appropriate duty control signal to the gated resistance may be used, including hardware and/or software elements. These can include an EEPROM capable of storing a suitable bit pattern input or even, in the simplest realisation of the invention, a set of manually controllable switches adapted to set the duty ratio to be applied.

## Claims

1. Method of calibration of an electronic electricity meter including a converter adapted to receive at least one analogue input signal and to provide a digital output signal dependant on at least the value of the input signal, **characterised in that** the analogue input signal is fed to the converter via a gated resistance component, the resistance component being switched on and off according to a duty signal, the ratio of the on and off periods being chosen based on an external comparison of the input and output values so as to calibrate the digital output value relative to the analogue input.

2. Method of calibration as claimed in claim 1 in which the input signal is fed to the converter via a resistor divider, comprising a first and a second resistance in series together with the gated resistance component in parallel with the second resistance, the voltage over the second resistance being input to the converter.

3. Method of calibration as claimed in claim 1 or 2 in which the duty signal is provided by a microprocessor adapted to store one or more duty signal patterns.

4. Method of calibration as claimed in any preceding claim in which the analogue input signal corresponds to the voltage measured by the meter.

5. Method of calibration as claimed in claim 4 in which the switching frequency of the gated signal corresponds to and is synchronised with the frequency of the voltage measured by the meter.

6. Method of calibration as claimed in any preceding claim in which a plurality of duty cycles is stored in a microprocessor within the meter, the microprocessor being adapted to apply one or more duty cycles in dependance on the magnitude of the output signal from the converter.

7. Method of calibration as claimed in claim 6 in which the microprocessor may be adapted to apply two duty cycles representing two calibration settings, the output of the converter being used to determine the proportion of time for which each duty cycle is applied.

8. Method of calibration as claimed in claim 6 in which the duty cycle is defined by a binary bit pattern and in which the microprocessor is adapted to provide a first binary pattern duty signal unless interrupted by a pulse from the converter, in which case a second binary pattern duty signal is applied.

9. Electronic electricity meter including, inter alia, a converter and a gated resistance component and comprising means for calibrating according to the calibration method of any preceding claim.

## Patentansprüche

1. Verfahren zur Kalibrierung eines elektronischen Elektrizitätszählers mit einem Wandler, dazu geeignet, mindestens ein analoges Eingabesignal zu empfangen und ein digitales Ausgabesignal zu liefern, welches mindestens von dem Wert des Eingabesignals abhängt, **dadurch gekennzeichnet, dass** das analoge Eingabesignal dem Wandler über ein Gatewiderstandteil zugeführt wird, wobei das Widerstandteil einem Betriebssignal entsprechend ein- und ausgestellt wird, wobei das Verhältnis zwischen der Ein- und Auszeiten aufgrund eines äußeren Vergleichs zwischen den Eingabe- und Ausgabewerten ausgewählt wird, um den digitalen Ausgabewert hinsichtlich der analogen Eingabe zu kalibrieren.

2. Kalibrierverfahren nach Anspruch 1, in welchem das Eingabesignal dem Wandler über einen Widerstandteiler zugeführt wird, mit einem ersten und einem zweiten gereihten Widerstand zusammen mit dem Gatewiderstandteil parallel zu dem zweiten Widerstand, wobei die Spannung über dem zweiten Widerstand in den Wandler eingegeben wird.

3. Kalibrierverfahren nach Anspruch 1 oder 2, in welchem das Betriebssignal von einem Mikroprozessor geliefert wird, welcher geeignet ist, ein oder mehrere Betriebssignalschemen zu speichern.

4. Kalibrierverfahren nach einem der vorangehenden Ansprüche, in welchem das analoge Eingabesignal der von dem Zähler gemessenen Spannung entspricht.

5. Kalibrierverfahren nach Anspruch 4, in welchem die Schaltfrequenz des Gatesignals der Frequenz der von dem Zähler gemessenen Spannung entspricht und mit ihr synchronisiert ist.

6. Kalibrierverfahren nach einem der vorangehenden Ansprüche, in welchem eine Mehrzahl von Betriebszyklen in einem Mikroprozessor innerhalb des Zählers gespeichert ist,
wobei der Mikroprozessor geeignet ist, einen oder mehrere Betriebszyklen in Abhängigkeit von der Größenordnung des Ausgabesignals von dem Wandler einzusetzen.

7. Kalibrierverfahren nach Anspruch 6, in welchem der Mikroprozessor dazu geeignet sein kann, zwei Betriebszyklen, welche zwei Kalibriereinstellungen darstellen, einzusetzen, wobei die Ausgabe des Wandlers benutzt wird, um den Zeitanteil, für den jeder Betriebszyklus eingesetzt wird, zu bestimmen.

8. Kalibrierverfahren nach Anspruch 6, in welchem der Betriebszyklus durch ein binäres Bitschema bestimmt wird, und in welchem der Mikroprozessor geeignet ist, ein erstes Binärschema-Betriebssignal zu liefern, es sei denn es wird durch einen Puls von dem Wandler unterbrochen, in welchem Fall ein zweites Binärschema-Betriebssignal eingesetzt wird.

9. Elektronsicher Elektrizitätszähler mit unter anderem einem Wandler und einem Gatewiderstandteil und welcher Kalibriermittel umfasst, welche dem Kalibrierverfahren nach einem der vorangehenden Ansprüche entsprechen.

## Revendications

1. Procédé d'étalonnage d'un compteur d'électricité électronique comprenant un convertisseur adapté pour recevoir au moins un signal d'entrée analogique et pour fournir un signal de sortie numérique en fonction d'au moins la valeur du signal d'entrée, **caractérisé en ce que** le signal d'entrée analogique est alimenté au convertisseur par l'intermédiaire d'un composant à résistances à déclenchement, le composant à résistances étant mis en service et hors service en fonction d'un signal d'utilisation, le rapport entre les périodes de mise en service et de mise hors service étant choisi sur la base d'une comparaison externe entre les valeurs d'entrée et de sortie de manière à étalonner la valeur de sortie numérique en fonction de l'entrée analogique.

2. Procédé d'étalonnage selon la revendication 1, dans lequel le signal d'entrée est alimenté au convertisseur par l'intermédiaire d'un diviseur à résistances comprenant une première et une deuxième résistance en série avec le composant à résistances à déclenchement en parallèle à la seconde résistance, la tension sur la seconde résistance étant entrée dans le convertisseur.

3. Procédé d'étalonnage selon la revendication 1 ou 2, dans lequel le signal d'utilisation est fourni par un microprocesseur adapté pour enregistrer une ou plusieurs configurations de signal.

4. Procédé d'étalonnage selon l'une quelconque des revendications précédentes, dans lequel le signal d'entrée analogique correspond à la tension mesurée par le compteur.

5. Procédé d'étalonnage selon la revendication 4, dans lequel la fréquence de commutation du signal à déclenchement correspond à et est synchronisée avec la fréquence de la tension mesurée par le compteur.

6. Procédé d'étalonnage selon l'une quelconque des revendications précédentes, dans lequel une pluralité de cycles d'utilisation est enregistrée dans un microprocesseur à l'intérieur du compteur, le microprocesseur étant adapté pour appliquer un ou plusieurs cycles d'utilisation en fonction de l'amplitude du signal de sortie provenant du convertisseur.

7. Procédé d'étalonnage selon la revendication 6, dans lequel le microprocesseur peut être adapté pour appliquer deux cycles d'utilisation représentant deux réglages d'étalonnage, la sortie du convertisseur étant utilisée pour déterminer la proportion de temps pour laquelle chaque cycle d'utilisation est appliqué.

8. Procédé d'étalonnage selon la revendication 6, dans lequel le cycle d'utilisation est défini par une configuration binaire et dans lequel le microprocesseur est adapté pour fournir un premier signal d'utilisation de configuration binaire à moins d'être interrompu par une impulsion provenant du convertisseur, auquel cas un second signal d'utilisation de configuration binaire est appliqué.

9. Compteur d'électricité électronique comprenant, entre autre, un convertisseur et un composant à résistances à déclenchement comprenant des moyens d'étalonnage selon le procédé d'étalonnage selon l'une quelconque des revendications précédentes.
